# EUROPEAN PATENT APPLICATION

(11) **EP 4 801 203 A1**
(43) Date of publication of application: **02.09.2026**
(21) Application number: 24882783.4
(22) Date of filing: 22.10.2024
(51) Int. Cl.: H05K 1/16, H05K 3/40, H05K 3/00, H05K 1/02, H05K 1/09, H05K 3/12, H05K 3/46

(54) **CIRCUIT BOARD**

(30) Priority: 24.10.2023 KR 20230143329; 23.08.2024 KR 20240113830; 23.08.2024 KR 20240113831; 23.08.2024 KR 20240113832; 09.09.2024 KR 20240122536
(71) Applicant: Yura Corporation Co., Ltd., Seongnam-si, Gyeonggi-do 13494 (KR)
(72) Inventor: SA, Kwang Ouk, Seoul 08734 (KR); KIM, Seung Hyun, Siheung-si, Gyeonggi-do 15120 (KR); KIM, Han Gyu, Yongin-si, Gyeonggi-do 16977 (KR)
(74) Representative: ABG Intellectual Property Law, S.L.
(86) International application number: PCT/KR2024/016104
(87) International publication number: WO 2025/089756

(57) **Abstract**

Disclosed is a circuit board comprising: a chip fuse mounting conductive wire forming a circuit pattern and disconnected in the middle; a chip fuse mounted on the disconnected portion of the chip fuse mounting conductive wire to block a current from flowing through the circuit pattern in an overcurrent event; a pattern fuse conductive wire arranged in parallel with the chip fuse mounting conductive wire and disconnected in the middle; and a pattern fuse formed in the disconnected portion of the pattern fuse conductive wire to block a current from flowing through the circuit pattern in the overcurrent event. Therefore, even if the chip fuse is damaged, the pattern fuse can properly respond to the blocking capacity.

## Description

### TECHNICAL FIELD

The present invention relates to a circuit board, and more particularly, to a circuit board provided with a circuit breaking function against overcurrent.

### BACKGROUND ART

Unless otherwise disclosed in this specification, the contents described in these identification items are not prior art with respect to the claims of this application, and it is not considered that they constitute the prior art merely because they are mentioned in these identification items.

Circuit boards or printed circuit boards are manufactured for fixing and connecting a large number of electronic components in a standardized manner. Such a circuit board is a board, on which internal circuits are patterned and printed, and configured to mechanically and electrically couple a plurality of circuits so as to achieve miniaturization and lightweighting of electrical products.

The circuit board has advantages of stable circuit characteristics, no risk of mis-wiring, and low production costs. Due to these various advantages, the printed circuit board is used in a variety of fields and has become an essential component that is necessary for all electronic devices. Particularly, in recent years, with the trend toward smaller and lighter sizes, the use of flexible printed circuit boards has been increasing.

The printed circuit board is provided with a fuse circuit for protecting components mounted on the printed circuit board. The fuse circuit may use a chip fuse in the form of a chip. However, the chip fuse may be damaged during soldering to the board or may protrude from a surface of the board during mounting. Thus, when subjected to an external impact, cracks may occur in the soldered portion, resulting in a loss of the function. In this case, there is a problem in that it is completely unable to perform a function of protecting a circuit.

### DISCLOSURE OF THE INVENTION

### TECHNICAL PROBLEM

An embodiment of the present invention has been devised to solve the above-mentioned problems, and an object of the present invention is to provide a circuit board capable of protecting a circuit even when a chip fuse is damaged.

### TECHNICAL SOLUTION

In order to solve the above-mentioned problems, an embodiment of the present invention provides a circuit board including: a chip fuse mounting conductive wire configured to provide a circuit pattern and disconnected at an intermediate portion thereof; a chip fuse mounted at the disconnected portion of the chip fuse mounting conductive wire to block current flowing through the circuit pattern when overcurrent occurs; a pattern fuse conductive wire disposed in parallel to the chip fuse mounting conductive wire and connected at an intermediate portion thereof; and a pattern fuse disposed at the disconnected portion of the pattern fuse conductive wire to block the current flowing through the circuit pattern when the overcurrent occurs.

The chip fuse and the pattern fuse may have different blocking capacities.

The blocking capacity of the pattern fuse may be greater than the blocking capacity of the chip fuse.

The chip fuse and the pattern fuse may be disposed on the same plane.

The circuit board may further include a first protective pattern provided between the pattern fuse and the chip fuse to cover one side surface of the pattern fuse.

The circuit board may further include a second protective pattern configured to cover the other side surface of the pattern fuse at an opposite side of the pattern fuse, on which the first protective pattern is disposed.

A chip fuse layer on which the chip fuse is disposed and a pattern fuse layer on which the pattern fuse may be disposed are stacked so that the chip fuse and the pattern fuse are disposed in a thickness direction of the circuit board, and the circuit board may further include: a via hole passing through the chip fuse layer and the pattern fuse layer; and a connection conductor filled in the via hole.

The circuit board may further include a heat capacity reduction unit, on which the circuit pattern is disposed, on the chip fuse layer facing the pattern fuse.

The circuit board may further include a rigidity-increasing pattern unit disposed on the pattern fuse layer so as not to be electrically connected to the pattern fuse.

An embodiment of the present invention provides a circuit board including: a first insulating layer made of a non-conductive material; a first adhesive layer disposed at an upper side of the first insulating layer; a pattern unit disposed on a top surface of the first adhesive layer to provide a conductive pattern; a second adhesive layer disposed at an upper side of the pattern unit; and a second insulating layer disposed at an upper side of the second adhesive layer and made of a non-conductive material, wherein the pattern unit includes a pattern fuse including a fusing part that is disconnected when a certain level or more of current flows, and at least one of the first insulating layer or the second insulating layer, on which the pattern fuse is disposed, is made of a transparent material.

At least one of the first adhesive layer or the second adhesive layer, on which the pattern fuse is disposed, may contain an irreversible cationic pigment of which a color is changed when a temperature increases.

The irreversible cationic pigment may be selected from copper sulfate anhydrous, and copper sulfate.

An embodiment of the present invention provides a circuit board including: a plurality of pattern fuses disposed in parallel; and a plurality of chip seating parts which are connected in series to the plurality of pattern fuses, respectively, and are provided to be disconnected, wherein the plurality of pattern fuses have different capacities.

The circuit board may further include a chip resistor installed on any one of the plurality of seating parts.

The chip resistor may include an anti-surge function.

The circuit board may further include a jump pin installed on any one of the plurality of seating parts.

The circuit board may further include a first protective pattern disposed at a predetermined distance to protect one side surface of each of the pattern fuses.

The circuit board may further include a second protective pattern configured to cover the other side surface of the pattern fuse at an opposite side of the pattern fuse, at which the first protective pattern is disposed.

An embodiment of the present invention provides a circuit board including: a first insulating layer made of a non-conductive material; a first adhesive layer disposed at an upper side of the first insulating layer; a pattern unit disposed on a top surface of the first adhesive layer to provide a conductive pattern; a second adhesive layer disposed at an upper side of the pattern unit; and a second insulating layer disposed at an upper side of the second adhesive layer and made of a non-conductive material, wherein the pattern unit includes a pattern fuse including a fusing part that is disconnected when a certain level or more of current flows, and the fusing part is provided with a copper and tin alloy layer.

The copper and tin alloy layer may include: a first allow layer made of Cu₃Sn; and a second allow layer made of Cu₆Sn₅.

The present invention provides a circuit board including: a first insulating layer made of a non-conductive material; a first adhesive layer disposed at an upper side of the first insulating layer; a pattern unit disposed on a top surface of the first adhesive layer to provide a conductive pattern; a second adhesive layer disposed at an upper side of the pattern unit; and a second insulating layer disposed at an upper side of the second adhesive layer and made of a non-conductive material, wherein the pattern unit includes a pattern fuse a fusing part that is disconnected when a certain level or more of current flows, and the circuit board further includes a solder paste applied between the fusing layer and the second adhesive layer and containing tin.

In addition, the present invention provides a method for manufacturing a circuit board, the method including: preparing a first insulating layer made of a non-conductive material; allowing a first adhesive layer to adhere to an upper side of the first insulating layer; allowing a pattern unit including a pattern fuse, on which a fusing part is formed, to adhere to a top surface of the first adhesive layer; applying solder paste containing tin to a top surface of the fusing part; applying a second adhesive layer to an upper side of the pattern unit to which the solder paste is applied; and allowing a second insulating layer made of a non-conductive material to adhere to a top surface of the second adhesive layer.

The applying of the solder paste may include: positioning a stencil including an application part having an opened top surface of the fusing part; and applying the solder paste to the application part using a squeezing blade.

### ADVANTAGEOUS EFFECTS

As described above, various effects including the following facts may be expected according to the technical problems of the present invention. However, it is unnecessary to allow all of the following effects to be exerted.

Firstly, the circuit board according to the first embodiment of the present invention may have the advantage in that the chip fuse and the pattern fuse are disposed in parallel, so that even if the chip fuse is damaged, the pattern fuse are appropriately correspond to the blocking capacity.

In addition, the first protective pattern and the second protective pattern may be provided to prevent the copper fragments from being scattered and short-circuited with the patterns constituting other circuits or destroying the insulation performance during the process of blocking due to the fusion of the pattern fuses. In addition, it may also serve to prevent the pattern fuse from being easily folded by the external force or damaged by the cracks.

In addition, since either the first insulating layer or the second insulating layer is made of the transparent material, it is possible to easily determine whether the fusing part is in the folded state from the outside.

In addition, the irreversible cationic pigment may be added, and thus, when the fusing part is fused, the temperature may reach 1,083 degrees Celsius, which is the melting point of copper, and the color may be changed due to the irreversible cationic pigment. As a result, it may easily determine whether the fusing part is fused from the outside.

In addition, the copper and tin alloy layer may be disposed on the fusion part, it is possible to specify the position of the fusion part that is to be fused.

In the case of the second embodiment, the pattern fuse and the chip fuse may be disposed in parallel in the thickness direction, and thus, even if the pattern fuse and the chip fuse are disposed in parallel, the area occupied in the plane may be reduced.

In the circuit board of the third embodiment, the plurality of pattern fuses having the different capacities may be disposed in parallel, and the chip resistor may be connected to the chip seating part connected to the pattern fuse having the desired capacity. Thus, the various patterns having the different capacities may be utilized with the single board without the need to separately manufacture the boards having the different capacities.

### BRIEF DESCRIPTION OF THE DRAWINGS

FIG. 1 is a plan view of a circuit board according to a first embodiment of the present invention.
FIG. 2 is a cross-sectional view taken along line II-II of FIG. 1.
FIGS. 3 and 4 are cross-sectional view taken along line III-III of FIG. 4,

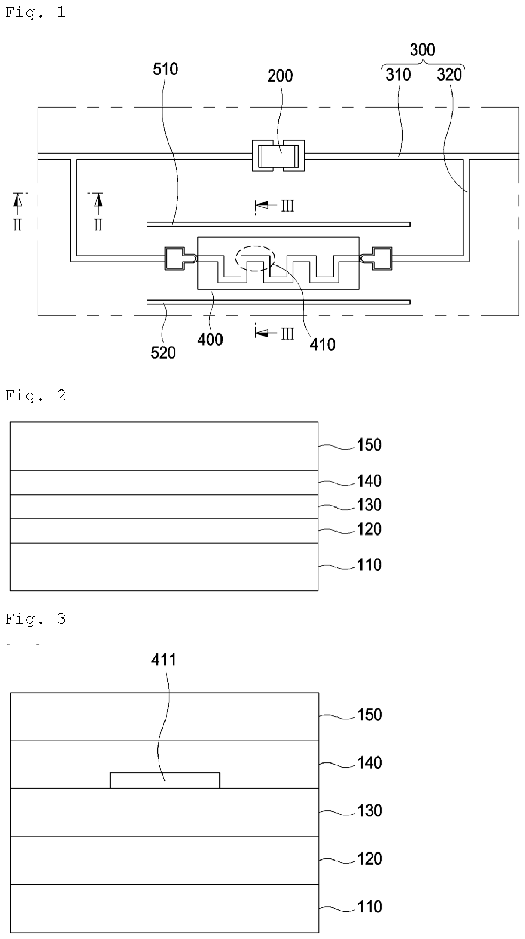

FIG. 3 is a cross-sectional view of a fusing part before a temperature of the fusing part increases,

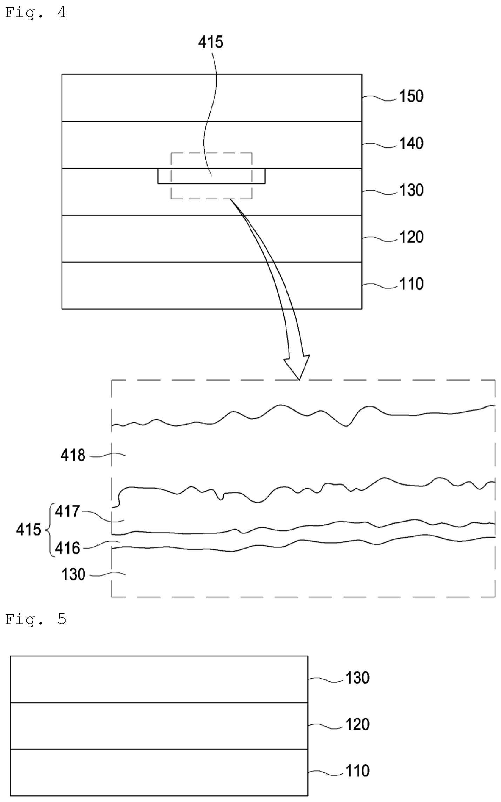

FIG. 4 is a cross-sectional view illustrating a state in which a copper and tin alloy layer is formed due to the increase in temperature of the fusing part.
FIGS. 5 to 7 are schematic cross-sectional views illustrating a method for manufacturing a circuit board including the fusing part of FIG. 3.

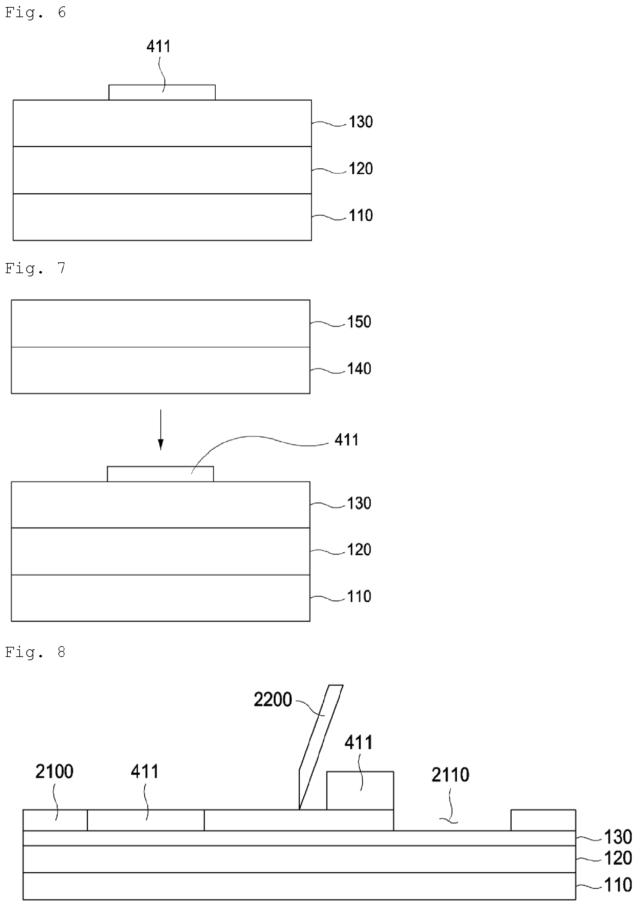

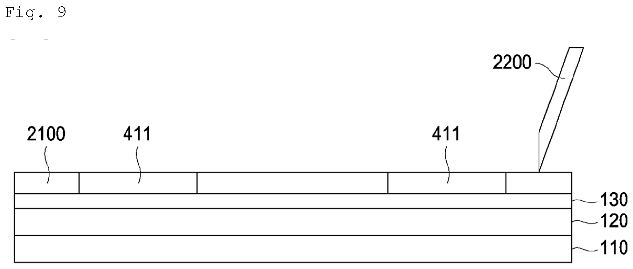

FIGS. 8 and 9 are cross-sectional views illustrating detailed processes in a step of applying solder paste of FIG. 6.

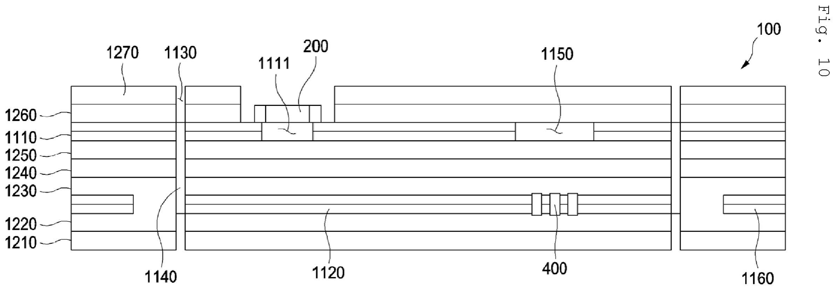

FIG. 10 is a cross-sectional view of a circuit board according to a second embodiment of the present invention.

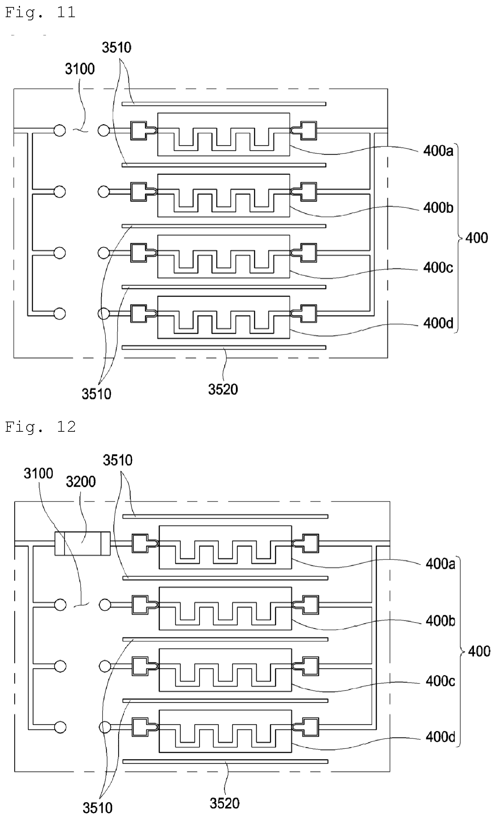

FIGS. 11 and 12 are views illustrating a circuit board according to a third embodiment of the present invention,
FIG. 11 is a plan view of the circuit board according to the third embodiment of the present invention.
FIG. 12 is a plan view illustrating a state in which a chip resistor is seated on the circuit board of FIG. 11.

### MODE FOR CARRYING OUT THE INVENTION

Hereinafter, exemplary embodiments will be described in detail with reference to the accompanying drawings.

FIG. 1 is a plan view of a circuit board according to a first embodiment of the present invention, and FIG. 2 is a cross-sectional view taken along line II-II of FIG. 1.

As illustrated in FIG. 1, the circuit board according to the first embodiment of the present invention includes a chip fuse mounting conductive wire 310, which provides a circuit pattern on a plane and of which an intermediate portion is disconnected, a chip fuse 200 mounted on a disconnected portion of the chip fuse mounting conductive wire 310 to block current flowing through the circuit pattern when overcurrent occurs, a pattern fuse conductive wire 320 which is disposed in parallel to the chip fuse mounting conductive wire 310 and of which an intermediate portion is disconnected, a pattern fuse 400 disposed at the disconnected portion of the pattern fuse conductive wire 320 to block the current flowing through the circuit pattern when the overcurrent occurs, a first protective pattern 510 disposed between the pattern fuse 400 and the chip fuse 200 to cover one side surface of the pattern fuse, and a second protective pattern 520 disposed at an opposite side of the pattern fuse 400, at which the first protective pattern 510 is disposed, to cover the other side surface of the pattern fuse 400.

In addition, as illustrated in the cross-sectional view of FIG. 2, the circuit board 100 includes a first insulating layer 110 made of a non-conductive material in a thickness direction of the circuit board 100, a first adhesive layer 120 disposed at an upper side of the first insulating layer 110, a pattern unit 130 disposed on a top surface of the first adhesive layer 120 to provide a conductive pattern, a second adhesive layer 140 disposed at an upper side of the pattern unit 130, and a second insulating layer 150 and made of a non-conductive material.

The chip fuse 200 that is a fuse in the form of a chip is a component in which an internal circuit within the chip is disconnected when an amount of current flowing through both ends thereof exceeds a certain capacity. Since the chip fuse 200 is generally well-known, detailed descriptions thereof will be omitted. The chip fuse may be damaged during soldering to the board or may protrude from a surface of the board during mounting. Thus, when subjected to an external impact, cracks may occur in the soldered portion, resulting in a loss of the function. In this case, there is a problem in that it is completely unable to perform a function of protecting a circuit.

The pattern unit 130 is made of a conductive material such as copper. In the pattern unit 130, the chip fuse mounting conductive wire 310, the pattern fuse conductive wire 320, the pattern fuse 400, the first protective pattern 510, and the second protective pattern 520 are provided as conductive patterns. Particularly, the chip fuse mounting conductive wire 310 and the pattern fuse conductive wire 320 constitute the pattern wire 300 that constitutes the circuit. The chip fuse mounting conductive wire 310 is provided by being disconnected so as to be able to connect the portions of the chip fuse 200 at which both ends of the chip fuse 200 are disconnected.

The pattern fuse conductive wire 320 is disposed in parallel with the chip fuse mounting conductive wire 310. That is, even if the chip fuse 200 is damaged, and electricity does not flow through the chip fuse mounting conductive wire 310, the electricity may still flow through the pattern fuse conductive wire 320.

The pattern fuse 400 is provided to have a smaller cross-sectional area compared to other pattern units 130 so that the pattern fuse 400 is fused when a certain level of current flows through the pattern fuse 400. The pattern fuse 400 is provided in a zigzag shape and includes a fusing part 410 that is disconnected when a certain level of current flows through a central portion thereof.

The chip fuse 200 and the pattern fuse 400 are provided to have blocking capacities that are different from each other. That is, it is preferable that the blocking capacity of the pattern fuse 400 is larger than the blocking capacity of the chip fuse. As described above, in the event of the excessive current flow, the chip fuse 200 is primarily fused, and then, the pattern fuse is fused. In addition, even in the event of damage of the chip fuse 200, the pattern fuse 400 may appropriately correspond to the blocking capacity. In the first embodiment, the chip fuse 200 and the pattern fuse 400 are disposed in parallel on the same plane.

The first protective pattern 510 and the second protective pattern 520 are copper patterns that are separately provided so as not to constitute the circuit. The first protective pattern 510 and the second protective pattern 520 serve to prevent scattering of copper fragments during the process in which the pattern fuse 400 is fused to be blocked due to abnormal current occurring in the pattern fuse 400, thereby preventing short circuit with the patterns constituting other circuits or the destruction of insulation performance. In addition, it also serves to prevent the pattern fuse 400 from being easily folded by external force or damaged due to cracking.

Each of the first insulating layer 110 and the second insulating layer 150 are made of a non-conductive material. In addition, at least one of the first insulating layer 110 or the second insulating layer 150, at which the pattern fuse 400 is disposed, is made of a transparent material. As described above, since either the first insulating layer 110 or the second insulating layer 150 is made of the transparent material, it is possible to easily determine whether the fusing part 410 is in the folded state from the outside.

In addition, a non-reversible cationic pigment of which a color is changed when a temperature rises is added to at least one of the first adhesive layer 120 or the second adhesive layer 140, at which the pattern fuse 400 is disposed. It is preferable that the irreversible cationic pigment is selected from copper sulfate anhydrous and copper sulfate (CuSO₄). As described above, the irreversible cationic pigment may be added, and thus, when the fusing part is fused, the temperature reaches 1,083 degrees Celsius, which is the melting point of copper, and the color of the irreversible cationic pigment is changed. As a result, it becomes possible to easily determine whether the carpet part 410 is in a fused state from the outside.

FIGS. 3 and 4 are cross-sectional view taken along line III-III of FIG. 4, FIG. 3 is a cross-sectional view of the fusing part before a temperature of the fusing part increases, and FIG. 4 is a cross-sectional view illustrating a state in which the copper and tin alloy layer is formed due to the increase in temperature of the fusing part.

Referring first to FIG. 3, the solder paste 410 that is applied between the fusing part 410 and the second adhesive layer 140 and contains tin is further provided. The solder paste 411 has tin (Sn) as its main component.

FIG. 4 illustrates that electricity is conducted through the welding part 410 to form an alloy layer. In this case, the copper and tin alloy layer 415 is disposed on the welding part 410. The copper and tin alloy layer 415 includes a first alloy layer 416 disposed on a top surface of the pattern unit 130 made of copper and a second alloy layer 417 disposed on a top surface of the first alloy layer 416 and made of Cu₆Sn₅. A tin layer 418 of the solder paste 411 is disposed on a top surface of the second alloy layer 417.

The copper and tin alloy layer 415 is provided by penetrating tin between copper molecules due to heat generation when the electricity is conducted. The copper and tin alloy layer 415 has a melting temperature lower than that of copper, and thus, when overcurrent occurs, the fusing occurs at the fusion part 410 at which the copper and tin alloy layer 415 is disposed. That is, a fusing temperature of copper is 1,083 degrees Celsius, a fusing temperature of tin is 232 degrees Celsius, a temperature of the first alloy layer 416 is 730 degrees Celsius, and a fusing temperature of the second alloy layer 417 is 635 degrees Celsius.

As described above, the copper and tin alloy layer 415 may be disposed on the fusion part, it is possible to specify the position of the fusion part 410 that is to be fused.

Hereinafter, a method for manufacturing a circuit board including a fusing part according to the first embodiment will be described.

FIGS. 5 to 7 are schematic cross-sectional views illustrating a method for manufacturing a circuit board including the fusing part of FIG. 3, and FIGS. 8 and 9 are cross-sectional views illustrating detailed processes in a step of applying solder paste of FIG. 6.

As illustrated in these drawings, a method for manufacturing a circuit board includes a step (FIG. 5) of preparing a first insulating layer 110 made of a non-conductive material, a step (FIG. 5) of allowing a first adhesive layer 120 to adhere to an upper side of the first insulating layer 110, a step (FIG. 5) of allowing a pattern unit comprising a pattern fuse 400, on which a fusing part 410 is formed, to adhere to a top surface of the first adhesive layer 120, a step (FIG. 6) of applying solder paste 411 containing tin to a top surface of the fusing part 410, a step (FIG. 7) of applying a second adhesive layer 140 to an upper side of the pattern unit 130 to which the solder paste 411 is applied, and a step (see FIG. 7) of allowing a second insulating layer 150 made of a non-conductive material to adhere to a top surface of the second adhesive layer 140.

One of characteristic features of the present invention is the step (FIG. 6) of applying the solder paste 411. Thus, detailed descriptions thereof will be provided with reference to FIGS. 8 and 9, and the remaining descriptions will be omitted.

The step (FIG. 8) of applying the solder paste 411 includes a step (FIG. 8) of positioning a stencil 2100 including an application part 2110 having an opened top surface of the fusing part 410 and a step (FIG. 9) of applying the solder paste 411 to the application part 2110 using a squeezing blade 2200. That is, the opened portion of the stencil 2100 is the application part 2110, and the application part 2110 is positioned on the top surface of the fusing part 410. Then, after the solder paste is disposed on the top surface of the stencil 2100, the solder paste 411 is applied using the squeezing blade 2200.

As described above, the method for manufacturing the circuit board according to the present invention has an advantage of being able to apply an accurate amount of solder paste 411 at a desired position on the fusing part.

FIG. 10 is a cross-sectional view of a circuit board according to a second embodiment of the present invention.

The circuit board according to the second embodiment is characterized in that a chip fuse 200 and a pattern fuse 400 are disposed in parallel in a thickness direction of the circuit board.

That is, in the circuit board according to the second embodiment, a chip fuse layer 1110 on which the chip fuse 200 is disposed and a pattern fuse layer 1120 on which the pattern fuse 400 is disposed are stacked so that the chip fuse 200 and the pattern fuse 400 are disposed in the thickness direction of the circuit board 100, and the circuit board further includes a via hole 1130 passing through the chip fuse layer 1110 and the pattern fuse layer 1120, and a connection conductor 1140 filled in the via hole 1130.

In more detail, the circuit board 100 is provided by sequentially stacking and bonding a first insulating layer 1210, a first adhesive layer 1220, the pattern fuse layer 1120, a second adhesive layer 1230, a second insulating layer 1240, a third adhesive layer 1250, the chip fuse layer 1110, a fourth adhesive layer 1260, and a third insulating layer 1270 from the bottom to the top.

The first insulating layer 1210, the second insulating layer 1240, and the third insulating layer 1270 have the same material as the first insulating layer 110 and the second insulating layer 150 according to the first embodiment. In addition, the materials and configurations of the first adhesive layer 1220 and the second adhesive layer 1230, and the third adhesive layer 1250 and the fourth adhesive layer 1260 are the same as those of the first adhesive layer 120 and the second adhesive layer 140 according to the first embodiment.

The via hole 1130 is defining by passing through the entire circuit board 100, and the connection conductor 1140 is filled into the via hole 1130 to connect the pattern fuse layer 1120 to the chip fuse layer 1110. Each of the connection conductor 1140, the pattern fuse layer 1120, and the chip fuse layer 1110 is made of a conductor such as copper.

The chip fuse layer 1110 further include a chip fuse adhesive unit 1111 connected so that both ends of the chip fuse 200 are seated, and a heat capacity reduction unit 1150, which is disposed on the chip fuse layer 1110 facing the pattern fuse 400, and in which no circuit pattern is provided. The heat capacity reduction unit 1150 is filled with an adhesive of the third adhesive layer 1250 and the fourth adhesive layer 1260. The heat capacity reduction unit 1150 reduces its ability to accommodate or transfer heat generated in the pattern fuse 400, thereby allowing the pattern fuse 400 to be melted at a desired time point.

The pattern fuse layer 1120 includes the pattern fuse 400 provided to serve as a fuse, and a rigidity-increasing pattern unit 1160 disposed on the pattern fuse layer 1120 so as not to be electrically connected to the pattern fuse 400. The rigidity-increasing pattern unit 1160 serves as a dummy pattern to prevent a decrease in rigidity of the portion at which the pattern is not disposed.

The pattern fuse 400 and the chip fuse 200 are the same as those of the first embodiment, and thus, detailed descriptions thereof are omitted.

As described above, in the circuit board of the second embodiment, the chip fuse and the pattern fuse are disposed in parallel with each other, like in the first embodiment. Therefore, even if the chip fuse is damaged, the pattern fuse may appropriately correspond to the blocking capacity.

In addition, in the case of the second embodiment, although the pattern fuse and the chip fuse are disposed in parallel, there is also an advantage of reducing an area occupied in the plane.

FIGS. 11 and 12 are views illustrating a circuit board according to a third embodiment of the present invention, FIG. 11 is a plan view of the circuit board according to the third embodiment of the present invention, and FIG. 12 is a plan view illustrating a state in which a chip resistor is seated on the circuit board of FIG. 11.

A circuit board according to a third embodiment includes a plurality of pattern fuses 400 disposed in parallel, a plurality of chip seating parts 3100 which are connected in series to the plurality of pattern fuses 400, respectively, and a chip resistor 3200 installed on one of the plurality of chip seating parts 3100.

The plurality of pattern fuses 400 have different capacities from each other. For example, allowable current of each of four pattern fuses 400 illustrated in FIG. 11 may be set to 0.75 A, 1 A, 2 A, and 3 A from the top to the bottom. In addition, a first protective pattern 3510 disposed spaced apart to protect one side surface of each of the pattern fuses 400, and a second protective pattern 3520 disposed at an opposite side of the pattern fuse, on which the first protective pattern 3510 is disposed, to cover the other side surface of the pattern fuse are provided.

Detailed configurations of the pattern fuse 400 and the board in a cross-sectional direction are the same as those of the pattern fuse 400 and the board in the cross-sectional direction according to the first embodiment. The configurations of the first protective pattern 3510 and the second protective pattern 3520 is the same as those of the first protective pattern 510 and the second protective pattern 520 according to the first embodiment.

The chip resistor 3200 includes an anti-surge function.

As described above, the chip seating part 3100 may be connected to a circuit board, on which the plurality of pattern fuses having different capacities are disposed in parallel, to connect the desired chip resistor to the pattern fuse 400 having a desired capacity. Thus, the various patterns having the different capacities may be utilized with the single board without the need to separately manufacture the boards having the different capacities.

Instead of using the chip resistor 3200, it may be implemented as a jump pin installed on one of the plurality of chip seating parts 3100.

Although the exemplary embodiment of the present invention is illustratively described, the technical scope of the present invention is not limited to only the specific embodiment, and thus all suitable modifications and equivalents coming with the scope of the appended claims.

## Claims

1. A circuit board comprising:
a chip fuse mounting conductive wire (310) configured to provide a circuit pattern and disconnected at an intermediate portion thereof;
a chip fuse (200) mounted at the disconnected portion of the chip fuse mounting conductive wire (310) to block current flowing through the circuit pattern when overcurrent occurs;
a pattern fuse conductive wire (320) disposed in parallel to the chip fuse mounting conductive wire (310) and connected at an intermediate portion thereof; and
a pattern fuse (400) disposed at the disconnected portion of the pattern fuse conductive wire (120) to block the current flowing through the circuit pattern when the overcurrent occurs.

2. The circuit board of claim 1, wherein the chip fuse (200) and the pattern fuse (400) have different blocking capacities.

3. The circuit board of claim 2, wherein the blocking capacity of the pattern fuse (400) is greater than the blocking capacity of the chip fuse.

4. The circuit board of claim 1, wherein the chip fuse (200) and the pattern fuse (400) are disposed on the same plane.

5. The circuit board of claim 4, further comprising a first protective pattern (510) provided between the pattern fuse (400) and the chip fuse (200) to cover one side surface of the pattern fuse.

6. The circuit board of claim 5, further comprising a second protective pattern (520) configured to cover the other side surface of the pattern fuse (400) at an opposite side of the pattern fuse (400), on which the first protective pattern (510) is disposed.

7. The circuit board of claim 1, wherein a chip fuse layer (1110) on which the chip fuse (200) is disposed and a pattern fuse layer (1120) on which the pattern fuse (400) is disposed are stacked so that the chip fuse (200) and the pattern fuse (400) are disposed in a thickness direction of the circuit board (100), and
the circuit board further comprises:
a via hole (1130) passing through the chip fuse layer (1110) and the pattern fuse layer (1120); and
a connection conductor (1140) filled in the via hole (1130).

8. The circuit board of claim 7, further comprising a heat capacity reduction unit (1150), on which the circuit pattern is disposed, on the chip fuse layer (1110) facing the pattern fuse (400).

9. The circuit board of claim 7, further comprising a rigidity-increasing pattern unit (1160) disposed on the pattern fuse layer (1120) so as not to be electrically connected to the pattern fuse (400).

10. The circuit board of claim 1, further comprising:
a first insulating layer (110) made of a non-conductive material;
a first adhesive layer (120) disposed at an upper side of the first insulating layer (110);
a pattern unit (130) disposed on a top surface of the first adhesive layer (120) to provide a conductive pattern;
a second adhesive layer (140) disposed at an upper side of the pattern unit (130); and
a second insulating layer (150) disposed at an upper side of the second adhesive layer (140) and made of a non-conductive material,
wherein the pattern unit (130) comprises a fusing part (410) that is disconnected when a certain level or more of current flows, so as to provide the pattern fuse (400), and
at least one of the first insulating layer (110) or the second insulating layer (150), on which the pattern fuse (400) is disposed, is made of a transparent material.

11. The circuit board of claim 10, wherein at least one of the first adhesive layer (120) or the second adhesive layer (140), on which the pattern fuse (400) is disposed, contains an irreversible cationic pigment of which a color is changed when a temperature increases.

12. The circuit board of claim 11, wherein the irreversible cationic pigment is selected from copper sulfate anhydrous, and copper sulfate (CuSO₄).

13. The circuit board of claim 1, further comprising:
a first insulating layer (110) made of a non-conductive material;
a first adhesive layer (120) disposed at an upper side of the first insulating layer (110);
a pattern unit (130) disposed on a top surface of the first adhesive layer (120) to provide a conductive pattern;
a second adhesive layer (140) disposed at an upper side of the pattern unit (130); and
a second insulating layer (150) disposed at an upper side of the second adhesive layer (140) and made of a non-conductive material,
wherein the pattern unit (130) comprises a fusing part (410) that is disconnected when a certain level or more of current flows, so as to provide the pattern fuse (400), and
the fusing part (410) is provided with a copper and tin alloy layer (415).

14. The circuit board of claim 13, wherein the copper and tin alloy layer (415) comprises:
a first allow layer (416) made of Cu₃Sn; and
a second allow layer (417) made of Cu₆Sn₅.

15. The circuit board of claim 1, further comprising:
a first insulating layer (110) made of a non-conductive material;
a first adhesive layer (120) disposed at an upper side of the first insulating layer (110);
a pattern unit (130) disposed on a top surface of the first adhesive layer (120) to provide a conductive pattern;
a second adhesive layer (140) disposed at an upper side of the pattern unit (130); and
a second insulating layer (150) disposed at an upper side of the second adhesive layer (140) and made of a non-conductive material,
wherein the pattern unit (130) comprises a fusing part (410) that is disconnected when a certain level or more of current flows, so as to provide the pattern fuse (400), and
the circuit board further comprises a solder paste (411) applied between the fusing layer (410) and the second adhesive layer (140) and containing tin.

16. A method for manufacturing a circuit board, the method comprising:
preparing a first insulating layer (110) made of a non-conductive material;
allowing a first adhesive layer (120) to adhere to an upper side of the first insulating layer (110);
allowing a pattern unit comprising a pattern fuse (400), on which a fusing part (410) is formed, to adhere to a top surface of the first adhesive layer (120);
applying solder paste (411) containing tin to a top surface of the fusing part (410);
applying a second adhesive layer (140) to an upper side of the pattern unit (130) to which the solder paste (411) is applied; and
allowing a second insulating layer (150) made of a non-conductive material to adhere to a top surface of the second adhesive layer (140).

17. The method of claim 16, wherein the applying of the solder paste comprises:
positioning a stencil (2100) comprising an application part (2110) having an opened top surface of the fusing part (410); and
applying the solder paste (411) to the application part (2110) using a squeezing blade (2200).

18. A circuit board comprising:
a first insulating layer (110) made of a non-conductive material;
a first adhesive layer (120) disposed at an upper side of the first insulating layer (110);
a pattern unit (130) disposed on a top surface of the first adhesive layer (120) to provide a conductive pattern;
a second adhesive layer (140) disposed at an upper side of the pattern unit (130); and
a second insulating layer (150) disposed at an upper side of the second adhesive layer (140) and made of a non-conductive material,
wherein the pattern unit (130) comprises a pattern fuse (400) comprising a fusing part (410) that is disconnected when a certain level or more of current flows, and
at least one of the first insulating layer (110) or the second insulating layer (150), on which the pattern fuse (400) is disposed, is made of a transparent material.

19. The circuit board of claim 18, wherein at least one of the first adhesive layer (120) or the second adhesive layer (140), on which the pattern fuse (400) is disposed, contains an irreversible cationic pigment of which a color is changed when a temperature increases.

20. The circuit board of claim 19, wherein the irreversible cationic pigment is selected from copper sulfate anhydrous, and copper sulfate (CuSO₄).

21. A circuit board comprising:
a plurality of pattern fuses (400) disposed in parallel; and
a plurality of chip seating parts which are connected in series to the plurality of pattern fuses (400), respectively, and are provided to be disconnected,
wherein the plurality of pattern fuses (400) have different capacities.

22. The circuit board of claim 21, further comprising a chip resistor (3200) installed on any one of the plurality of seating parts (3100).

23. The circuit board of claim 22, wherein the chip resistor (3200) comprises an anti-surge function.

24. The circuit board of claim 21, further comprising a jump pin installed on any one of the plurality of seating parts (3100).

25. The circuit board of claim 21, further comprising a first protective pattern (3510) disposed at a predetermined distance to protect one side surface of each of the pattern fuses (400).

26. The circuit board of claim 25, further comprising a second protective pattern (3520) configured to cover the other side surface of the pattern fuse at an opposite side of the pattern fuse, at which the first protective pattern (3510) is disposed.

27. A circuit board comprising:
a first insulating layer (110) made of a non-conductive material;
a first adhesive layer (120) disposed at an upper side of the first insulating layer (110);
a pattern unit (130) disposed on a top surface of the first adhesive layer (120) to provide a conductive pattern;
a second adhesive layer (140) disposed at an upper side of the pattern unit (130); and
a second insulating layer (150) disposed at an upper side of the second adhesive layer (140) and made of a non-conductive material,
wherein the pattern unit (130) comprises a pattern fuse (400) comprising a fusing part (410) that is disconnected when a certain level or more of current flows, and
the fusing part (410) is provided with a copper and tin alloy layer (415).

28. The circuit board of claim 27, wherein the copper and tin alloy layer (415) comprises:
a first allow layer (416) made of Cu₃Sn; and
a second allow layer (417) made of Cu₆Sn₅.

29. A circuit board comprising:
a first insulating layer (110) made of a non-conductive material;
a first adhesive layer (120) disposed at an upper side of the first insulating layer (110);
a pattern unit (130) disposed on a top surface of the first adhesive layer (120) to provide a conductive pattern;
a second adhesive layer (140) disposed at an upper side of the pattern unit (130); and
a second insulating layer (150) disposed at an upper side of the second adhesive layer (140) and made of a non-conductive material,
wherein the pattern unit (130) comprises a pattern fuse (400) a fusing part (410) that is disconnected when a certain level or more of current flows, and
the circuit board further comprises a solder paste (411) applied between the fusing layer (410) and the second adhesive layer (140) and containing tin.
